# EUROPEAN PATENT APPLICATION

(11) **EP 4 418 043 A1**
(43) Date of publication of application: **21.08.2024**
(21) Application number: 23157549.9
(22) Date of filing: 20.02.2023
(51) Int. Cl.: G03F 7/00, H01L 21/683

(54) **PATTERNING DEVICE LOADING METHOD**

(71) Applicant: ASML Netherlands B.V., 5500 AH Veldhoven (NL)
(72) Inventor: CATS, Selwyn, Yannick, Frithjof, 5500 AH Veldhoven (NL); GOOL, Elmar, Leon, 5500 AH Veldhoven (NL); YAKUNIN, Andrei, Mikhailovich, 5500 AH Veldhoven (NL); CLOIN, Christian, Gerardus, Norbertus, Hendricus, Marie, 5500 AH Veldhoven (NL)
(74) Representative: ASML Netherlands B.V.

(57) **Abstract**

A lithographic apparatus and method are provided, the method being of loading a patterning device to a support structure in a patterning device environment of a lithographic apparatus, the method comprising using a handling apparatus to bring a patterning device and a support structure together, energizing a clamp which secures the patterning device to the support structure, and then separating the handling apparatus and the patterning device, wherein a plasma is present between the handling apparatus and the patterning device whilst the handling apparatus and the patterning device are separating.

## Description

### FIELD

The present disclosure relates to a method of loading a patterning device to a support structure in a patterning device environment of a lithographic apparatus. The method may be used in a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a deep ultraviolet (DUV) wavelength of 193 nm.

A problem which may arise in an EUV lithographic apparatus is that an electrical discharge may occur, and when an electrical discharge does occur it may cause damage within the lithographic apparatus. For example, an electrical discharge may damage a patterning device within the lithographic apparatus. The patterning device may then need to be replaced, incurring significant down-time of the lithographic apparatus and incurring significant cost.

It may be desirable to provide a method of loading a patterning device which overcomes or mitigates one or more problems associated with the prior art.

### SUMMARY

According to a first aspect of the present disclosure, there is provided a method of loading a patterning device to a support structure in a patterning device environment of a lithographic apparatus, the method comprising using a handling apparatus to bring a patterning device and a support structure together, energizing a clamp which secures the patterning device to the support structure, and then separating the handling apparatus and the patterning device, wherein a plasma is present between the handling apparatus and the patterning device whilst the handling apparatus and the patterning device are separating.

Advantageously, the plasma reduces a risk of electrical discharge when the handling apparatus and the patterning device are separating.

The handling apparatus may hold a protective cover. The plasma may be provided between the protective cover and the patterning device.

Separating the handling apparatus and the patterning device may comprise moving the handling apparatus away from the patterning device.

A plasma may be present between the handling apparatus and the patterning device whilst the patterning device and the support structure are being brought together.

Bringing the patterning device and the support structure together may comprise the handling apparatus moving the patterning device towards the support structure.

A plasma may be present between the handling apparatus and the patterning device before the handling apparatus begins moving the patterning device to the support structure.

A plasma may be present between the handling apparatus and the patterning device secured to the support structure whilst the handling and the patterning device are being brought together.

A plasma may be present between the support structure and the patterning device whilst the handling apparatus and the patterning device are being separated from the support structure. This may comprise moving the handling apparatus and patterning device away from the support structure and/or may comprise moving the support structure away from the handling apparatus and patterning device.

The plasma may be generated for a period of at least 0.1 seconds.

The plasma may be an EUV-induced plasma generated by directing an EUV radiation beam into the patterning device environment.

The EUV radiation beam may be incident upon one or more masking blades.

The one or more masking blades may be arranged such that the one or more masking blades block the EUV radiation beam.

The plasma may be generated using an ionizer apparatus.

According to a second aspect of the invention there is provided a lithographic apparatus comprising a support structure for supporting a patterning device, a handling apparatus for handling the patterning device, and a controller, wherein the controller is configured to bring the patterning device and the support structure together, energize a clamp which secures the patterning device to the support structure, and then separate the handling apparatus and the patterning device, wherein the controller is configured to provide a plasma between the handling apparatus and the patterning device whilst the handling apparatus and the patterning device are separating.

Advantageously, the plasma reduces a risk of electrical discharge when the handling apparatus and the patterning device are separating.

According to a third aspect of the invention there is provided a lithographic system comprising the lithographic apparatus of the second aspect, and further comprising a radiation source, wherein the controller is configured to provide the plasma by moving a masking blade such that it blocks an EUV radiation beam provided by the radiation source.

Features of different aspects of the disclosure may be combined together.

### BRIEF DESCRIPTION OF THE DRAWINGS

Embodiments of the disclosure will now be described, by way of example only, with reference to the accompanying schematic drawings, in which:
- Figure 1 schematically depicts a lithographic system which may perform a method according to an embodiment of the disclosure;
- Figure 2 schematically depicts a method of loading a patterning device according to an embodiment of the disclosure; and
- Figures 3A-3F schematically depict the method of Figure 2 in more detail.

### DETAILED DESCRIPTION

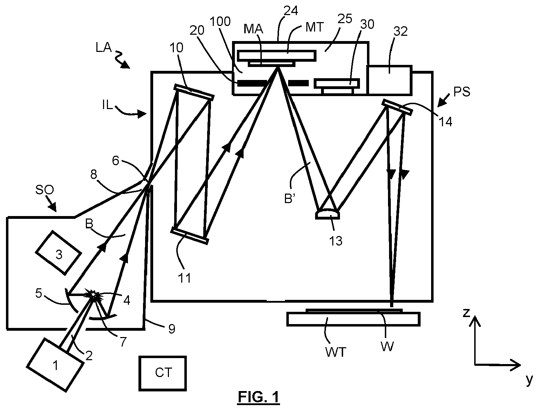

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The patterning device MA and other elements may be provided within a housing 24. An interior defined by the housing may be referred to as a patterning device environment 25. The housing 24 may be substantially closed, apart from an opening at a bottom end of the housing. Masking blades 20 are provided in the patterning device environment 25. The masking blades 20 are used to selectively mask areas of the patterning device MA, such that only a desired portion of the patterning device receives EUV radiation at any given time.

During a scanning exposure, the patterning device MA and support structure MT move in the y-direction, and the substrate W and substrate table WT move in the opposite y-direction (and vice-versa). In this way, a band of EUV radiation passes over the patterning device MA and passes over an exposure field on the substrate W.

A patterning device handling apparatus 30 (which may be referred to as a handling apparatus) is provided within the patterning device environment 25. The handling apparatus 30 is used to remove a patterning device MA from the support structure MT and swap the removed patterning device for a different patterning device. The handling apparatus 30 may place the removed patterning device MA in a patterning device storage apparatus 32 (which may be referred to as a storage apparatus). The handling apparatus 30 may take a different patterning device MA from the storage apparatus 32. The handling apparatus 30 may move this different patterning device MA such that it comes into contact with and is held by the support structure MT. The handling apparatus 30 may then move away from the patterning device MA before lithographic exposures begin. A plasma may be present between the handling apparatus 30 and the patterning device MA whilst the handling apparatus is moving away from the patterning device (as explained further below).

A relative vacuum, i.e. a small amount of gas (e.g. hydrogen) at a pressure well below atmospheric pressure, may be provided in the radiation source SO, in the illumination system IL, and/or in the projection system PS. The same is also the case for the patterning device environment 25. That is, gas at a pressure below atmospheric pressure is present in the patterning device environment 25. The gas may for example be hydrogen.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Operation of the radiation source SO may be controlled by a controller CT.

Although Figure 1 depicts the radiation source SO as a laser produced plasma (LPP) source, any suitable source such as a discharge produced plasma (DPP) source or a free electron laser (FEL) may be used to generate EUV radiation.

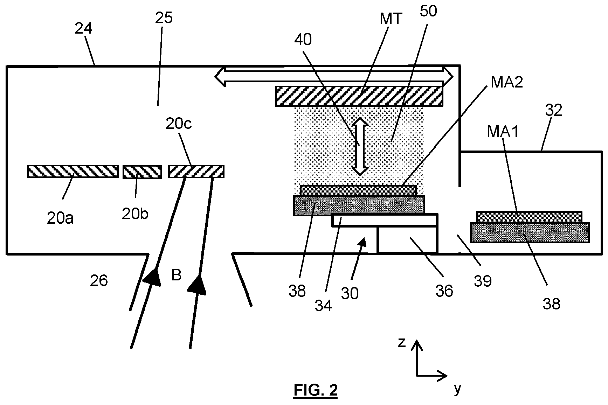

Figure 2 schematically depicts part of the lithographic apparatus LA in more detail. Figure 2 schematically depicts the housing 24 of the patterning device environment 25, the support structure MT, the masking blades 20 and the handling apparatus 30. Figure 2 also depicts the patterning device storage apparatus 32. In Figure 2 the handling apparatus 30 is part-way between unloading a patterning device MA1 from the support MT and loading a different patterning device MA2 to the support structure MT.

The support structure MT is moveable in the Y-direction (i.e. a scanning-direction of the lithographic apparatus LA). The support structure MT has moved in the Y-direction such that it is located above the handling apparatus 30. The support structure MT may be at one end of its range of motion in the Y-direction.

The handling apparatus 30 comprises an arm 34 mounted on an actuator 36. The patterning device MA2 which is being manipulated by the handling apparatus 30 is held on a protective cover 38. The protective cover 38 is configured to reduce a risk of damage being caused to a pattern on the patterning device and/or contamination being incident upon a patterned lowermost surface of the patterning device MA2 when the patterning device is being manipulated or is being stored. The protective cover 38 may also protect a pellicle (if present) which is connected to the patterning device MA2. The patterned lowermost surface of the patterning device MA2 may be separated from the protective cover 38 such that it does not directly contact the protective cover, thereby avoiding damage being caused to the pattern by the protective cover.

The actuator 36 is configured to move the arm 34 upwards and downwards as indicated by the double-headed arrow 40. In addition, the actuator 36 is configured to move the arm 34 into and out of the patterning device storage apparatus 32 though an opening 39. This may be achieved for example by a combination of rotation of the arm 34 and extension of the arm in the Y-direction. In other arrangements, the arm 34 may move in a different manner in order to move a patterning device into and out of the patterning device storage apparatus 32.

As depicted in Figure 2, a patterning device MA1 and associated protective cover 38 have been removed from the support structure MT and placed into the patterning device storage apparatus 32. A different patterning device MA2 and associated protective cover 38 have been retrieved from the patterning device storage apparatus by the handling apparatus 30. The different patterning device MA2 may be referred to as the second patterning device MA2. In a next step, the handling apparatus 30 will move the second patterning device MA2 upwards until it comes into contact with the support structure MT. The support structure MT may be moved downwards in order to meet the second patterning device MA2. A clamp (not depicted) which forms part of the support structure MT is energized in order to secure the second patterning device MA2 to the support structure MT. The arm 34 and the protective cover 38 are then moved downwards and away from the second patterning device MA2 which remains fixed to the support structure MT.

As depicted in Figure 2, the masking blades 20 have been moved to a configuration which blocks the EUV radiation beam B. The masking blades 20 may comprise a pair of masking blades 20a,b which are moveable in the Y-direction. This pair of masking blades 20a,b are used during lithographic exposure to control a Y-direction size of a patterning device area which is illuminated by the EUV radiation beam B. The masking blades 20 may further comprise a pair of X-direction moveable blades. Only one of the X-direction moveable blades 20c is depicted in Figure 2. The X-direction masking blades may be used to control an X-direction size of a patterning device area which is illuminated by the EUV radiation beam during lithographic exposure. Thus, during lithographic exposure the masking blades 20 form a perimeter of an area through which the EUV radiation beam B travels before being incident upon a patterning device MA.

In Figure 2, the masking blades 20 have been positioned such that they block the EUV radiation beam B. The Y-direction masking blades 20a,b have been moved such that they are positioned away from the EUV radiation beam B. One of the X-direction masking blades 20c has been moved such that it extends fully across an area which is illuminated by the EUV radiation beam B (i.e. has extended fully across the EUV radiation beam in the X-direction). The EUV radiation beam B is thereby blocked by the X-direction masking blade. Other masking blade configurations which block the EUV radiation beam B may be used.

As noted further above, hydrogen (or other gas) is provided in the patterning device environment 25. The hydrogen gas may have a pressure which is below atmospheric pressure. The EUV radiation beam B is incident upon the hydrogen gas. The EUV radiation beam B ionizes hydrogen molecules of the hydrogen gas, thereby generating a plasma. This may be referred to as an EUV-induced plasma. In addition, the EUV radiation beam B may cause photo-emission of electrons from the masking blades 20. The photo-emitted electrons may form part of the EUV-induced plasma, and may cause further ionization of the hydrogen gas, thus further contributing to the EUV-induced plasma.

The plasma which is induced by the EUV radiation disperses within the patterning device environment 25. Thus, the plasma is present between the support structure MT and the second patterning device MA2. This is schematically indicated by a shaded area 50. In practice, the plasma 50 will be at other locations within the pattering device environment 25, but this is not depicted for ease of illustration. The plasma 50 is present between the support structure MT and the second patterning device MA when the handling apparatus 30 is moving the second patterning device towards the support structure. Similarly, after the clamp of the support structure MT has been energized in order to secure the second patterning device MA2, plasma is present between the protective cover 38 and the second patterning device as the protective cover is moved away from the second patterning device. Advantageously, the presence of the EUV-induced plasma during this loading procedure of the second patterning device MA2 onto the support structure MT neutralizes or substantially neutralizes electrical charge which may be present on the second patterning device MA2 and the protective cover 38. This reduces the risk of an electrical discharge between the second patterning device MA2 and the protective cover 38 when the protective cover is being moved away from the second patterning device. Similarly, the risk of electrical discharge between the second patterning device MA2 and the support structure MT, when the second patterning device MA2 is moving towards the support structure MT, is also reduced.

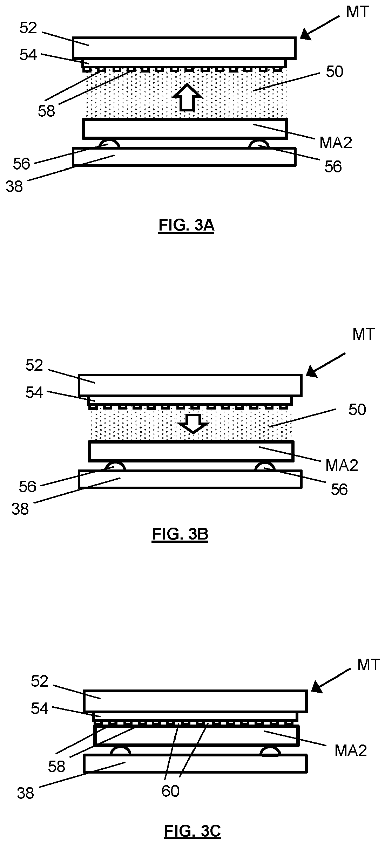

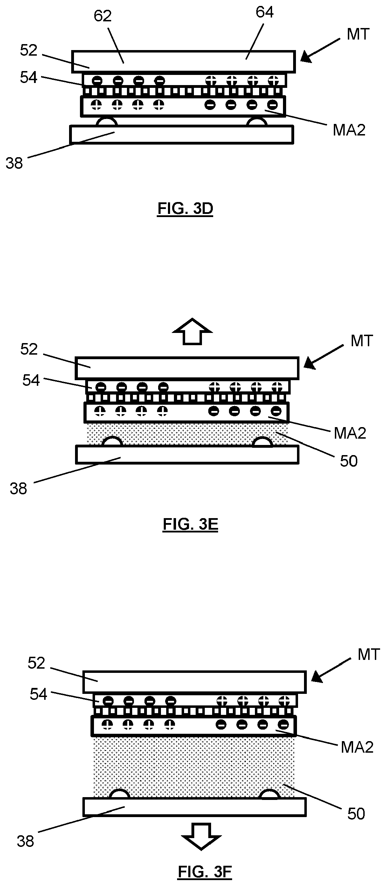

Figure 3 schematically depicts as a series of steps 3A-3F loading of a patterning device MA2 onto a support structure MT according to an embodiment of the disclosure.

Referring first to Figure 3A, a plasma 50 is provided between a patterning device MA2 and a support structure MT. As noted above, the plasma 50 is induced by EUV radiation being incident upon masking blades 20 within the patterning device environment 25. For ease of illustration, the plasma 50 is schematically depicted only between the patterning device MA2 and the support structure MT. However, the plasma 50 may be dispersed throughout the patterning device environment 25, e.g. such that it may occupy spaces between all components within the patterning device environment.

The support structure MT comprises a base 52 and a clamp 54. The clamp 54 may for example be an electrostatic clamp. The clamp 54 is provided with an array of burls 58. The patterning device MA2 is supported by a protective cover 38. The protective cover 38 includes protrusions 56 on which the patterning device MA2 rests. The protrusions 56 may be positioned such that they do not contact a patterned area of the patterning device MA2. Although the protective cover 38 is schematically depicted as being smaller than the patterning device MA2, in practice the protective cover may be larger than the patterning device.

In Figure 3A, the protective cover 38 and the patterning device MA2 are moving upwards towards the support structure MT. This movement may be provided by a handling apparatus 30 (not depicted).

As noted further above, the EUV-induced plasma 50 between the patterning device MA2 and the support structure MT neutralizes charge on the support structure MT and the patterning device MA2. This reduces a risk of an electrical discharge due to a potential difference existing between the patterning device MA2 and the support structure MT.

If the plasma 50 were not present, then there could be a risk of an electrical discharge. The handling apparatus 30 may carry some electrostatic charge, and may transfer some electrostatic charge to the patterning device MA2. Additionally or alternatively, the patterning device MA2 may itself already carry some electrostatic charge (e.g. acquired during a previous use or previous manipulation of the patterning device). The electrostatic charge could cause the electrical discharge (if no plasma were present). In general, the amount of charge carried by the patterning device MA2 when it is being loaded to the support structure MT may be unknown. In some cases the amount of charge may be sufficient to cause an electrical discharge, and in other cases the amount of charge may not be sufficient to cause an electrical discharge. The plasma 50 neutralizes the charge on the patterning device MA2. This means that a charge state of the patterning device MA2 is known (rather than being unknown as may be the case in prior art systems).

Referring to Figure 3B, the support structure MT is moved downwards towards the patterning device MA2. This movement of the support structure MT may take place after upward movement of the patterning device MA2 and protective cover 38 has been completed. Alternatively, the downward movement of the support structure MT may take place simultaneously with movement of the patterning device MA2 and protective cover 38 (or before movement of the patterning device and protective cover). The EUV-induced plasma 50 continues to be present between the patterning device MA2 and the clamp 54, and thus continues to reduce the risk of an electrical discharge.

In general, the EUV-induced plasma may be present between the patterning device MA2 and the clamp support structure MT when the patterning device and the support structure are being brought together.

Referring to Figure 3C, the patterning device MA2 comes into contact with the clamp 54. The patterning device MA2 contacts end surfaces of the burls 58. There is space around the burls, and as a result gaps 60 are present between the patterning device MA2 and a main body of the clamp 54. EUV-induced plasma may be present in those gaps 60.

Referring to Figure 3D, the electrostatic clamp 54 is energized. In the depicted embodiment, the clamp includes two electrodes 62, 64 which are electrically isolated from each other. In the depicted embodiment, a negative potential is applied to the first electrode 62, and a positive potential is applied to the second electrode 64. The negative potential applied to the first electrode 62 induces positive charge at a surface of the patterning device MA2 which faces towards the first electrode. The positive potential applied to the second electrode 64 induces negative charge at a surface of the patterning device MA2 which faces towards second first electrode. This provides electrostatic attraction which secures the patterning device MA2 to the clamp 54 and thus to the support structure MT. In other embodiments the electrostatic clamp may include a different number of electrodes (e.g. four electrodes).

Although not depicted, the EUV-induced plasma 50 may be present between the protective cover 38 and the patterning device MA2. EUV-induced plasma 50 may be present at sides of the protective cover 38 and the patterning device MA, and may connect conductive parts of the protective cover 38 to conductive parts of the patterning device. This connection via plasma may equalize an electrical potential between the protective cover 38 and the patterning device MA (i.e. such that there is no potential difference between the protective cover and the patterning device).

Referring to Figure 3E, the patterning device MA2 and the protective cover 38 are separated. This may be achieved by moving the support structure MT (and patterning device MA2) away from the protective cover 38 and/or moving the protective cover away from the support structure. In the depicted embodiment the support structure MT is moved upwards and away from the protective cover. This lifts the patterning device MA2 away from the protective cover 38. Separating the patterning device MA2 and the protective cover 38 may be liable to generate an electrical discharge because capacitance exists between a capacitor which is effectively formed by the protective cover 38 and the patterning device MA2. The capacitance reduces as a function of the distance between the protective cover 38 and the patterning device MA2, and as a result a potential difference between them will increase. The EUV-induced plasma 50 is present between the patterning device MA2 and the protective cover 38. EUV-induced plasma 50 neutralizes charge on the patterning device MA2 and on the protective cover 38. This reduces the risk of an electrical discharge occurring.

In general, the EUV-induced plasma 50 is present between the patterning device MA2 and the clamp support structure MT when the patterning device and the support structure are being separated.

Referring to Figure 3F, the protective cover 38 is moved downwards and away from the patterning device MA2. The EUV-induced plasma 50 remains between the protective cover 38 and the patterning device MA2, and thus reduces the risk of an electrical discharge occurring. In the absence of the EUV-induced plasma, the risk of an electrical discharge occurring would further increase as the separation between the patterning device MA2 and the protective cover 38 increases.

In a subsequent step (not depicted), the protective cover 38 may be moved into the storage apparatus 32. The masking blades 20 may be moved to a configuration which allows for lithographic exposures to be performed using the patterning device MA2.

In above described embodiments of the disclosure, the plasma which reduces the risk of an electrical discharge during reticle loading is EUV-induced plasma. To generate the EUV-induced plasma during loading of a patterning device, the radiation source SO may be operated at its usual power (i.e. with the power that is used when exposing substrates). The radiation source SO may be operated at a lower power, but doing so will generate less plasma.

In above described embodiments of the disclosure, a plasma is present in the patterning device environment when a patterning device is being loaded onto the support structure. In addition, a plasma may be present in the patterning device environment when a patterning device is being removed from the support structure (e.g. when the handling apparatus and the patterning device are being brought together, and when the handling apparatus and the patterning device are separated from the support structure).

The radiation source SO may be operated continuously to provide the EUV radiation beam B during unloading of a patterning device and loading of a replacement patterning device. This continuously induces plasma which neutralizes charge on components within the patterning device environment 25. Alternatively, the EUV radiation beam B may be used to generate plasma at points in the patterning device unloading and loading process during which there would otherwise be a risk of electrical discharge. For example, the EUV radiation beam B may be provided until a separation between the patterning device MA and the support structure MT drops below a threshold separation. This is because the patterning device MA and the support structure MT may already be neutralized once the separation drops below the threshold, and the risk of electrical discharge has become negligible. In general, the EUV radiation beam B may be interrupted when the risk of electrical discharge has become negligible.

It may be desirable to generate EUV-induced plasma when the patterning device MA and support structure MT are at a maximum separation from each other. This is because the maximum separation provides more volume for the EUV-induced plasma to enter. In addition, a capacitance established by the patterning device MA and support structure MT is at a minimum (and thus a potential difference between the patterning device and the support structure is at a maximum).

During a patterning device load process, it may be desirable to generate EUV-induced plasma for a period of time which is sufficient to neutralize the patterning device MA. This period of time may for example be less than 1 second. The period of time may for example be at least 0.1 second.

Although the plasma which reduces the risk of an electrical discharge during reticle loading is described as EUV-induced plasma, plasma may be generated in other ways. For example, an ionizer apparatus may be provided, the ionizer apparatus being configured to ionize the hydrogen gas (or other gas) in the patterning device environment. It may be advantageous to use EUV-induced plasma because doing so avoids the need for additional apparatus (e.g. an ionizer apparatus) to be provided.

In an embodiment, the protective cover may be omitted. Where this is the case, the patterning device may be handled directly by the handling apparatus. Alternatively, instead of the protective cover a different element may be provided between the patterning device and the handling apparatus.

Referring to Figure 1, the controller CT may be configured to control operation of the radiation source SO. The controller CT may be configured to also control the positions of the masking blades 20, and to control movement of the handling apparatus 30 and the support structure MT. The controller CT may be configured to apply a method according to an embodiment of the disclosure.

A method according to an embodiment of the disclosure may be performed by a computing device. The device may comprise a central processing unit ("CPU") to which is connected a memory. The method described herein may be implemented in code (software) stored on a memory comprising one or more storage media, and arranged for execution on a processor comprising on or more processing units. The storage media may be integrated into and/or separate from the CPU. The code, which may be referred to as instructions, is configured to be fetched from the memory and executed on the processor to perform operations in line with embodiments discussed herein. Alternatively it is not excluded that some or all of the functionality of the CPU is implemented in dedicated hardware circuitry, or configurable hardware circuitry like an FPGA.

The computing device may comprise an input configured to enable a user to input data into a software program running on the CPU. The input device may comprise a mouse, keyboard, touchscreen, microphone etc. The computing device may further comprises an output device configured to output results of measurements to a user.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the disclosure in the context of a lithographic apparatus, embodiments of the disclosure may be used in other apparatus. Embodiments of the disclosure may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the disclosure in the context of optical lithography, it will be appreciated that the disclosure, where the context allows, is not limited to optical lithography and may be used in other applications, for example imprint lithography.

Where the context allows, embodiments of the disclosure may be implemented in hardware, firmware, software, or any combination thereof. Embodiments of the disclosure may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the disclosure have been described above, it will be appreciated that the disclosure may be practiced otherwise than as described. The descriptions above are intended to be illustrative, not limiting. Thus it will be apparent to one skilled in the art that modifications may be made to the disclosure as described without departing from the scope of the claims set out below.

## Claims

1. A method of loading a patterning device to a support structure in a patterning device environment of a lithographic apparatus, the method comprising using a handling apparatus to bring a patterning device and a support structure together, energizing a clamp which secures the patterning device to the support structure, and then separating the handling apparatus and the patterning device, wherein a plasma is present between the handling apparatus and the patterning device whilst the handling apparatus and the patterning device are separating.

2. The method of claim 1, wherein the handling apparatus holds a protective cover, and the plasma is provided between the protective cover and the patterning device.

3. The method of any preceding claim, wherein separating the handling apparatus and the patterning device comprises moving the handling apparatus away from the patterning device.

4. The method of any preceding claim wherein a plasma is present between the handling apparatus and the patterning device whilst the patterning device and the support structure are being brought together.

5. The method of claim 4, wherein bringing the patterning device and the support structure together comprises the handling apparatus moving the patterning device towards the support structure.

6. The method of any preceding claim wherein a plasma is present between the handling apparatus and the patterning device before the handling apparatus begins moving the patterning device to the support structure.

7. The method of any preceding claim wherein a plasma is present between the handling apparatus and the patterning device secured to the support structure whilst the handling apparatus and the patterning device are being brought together.

8. The method of any preceding claim wherein a plasma is present between the support structure and the patterning device whilst the handling apparatus and the patterning device are being separated from the support structure.

9. The method of any preceding claim, wherein the plasma is generated for a period of at least 0.1 seconds.

10. The method of any preceding claim, wherein the plasma is an EUV-induced plasma generated by directing an EUV radiation beam into the patterning device environment.

11. The method of claim 10, wherein the EUV radiation beam is incident upon one or more masking blades.

12. The method of claim 11, wherein one or more masking blades are arranged such that the one or more masking blades block the EUV radiation beam.

13. The method of any preceding claim, wherein the plasma is generated using an ionizer apparatus.

14. A lithographic apparatus comprising a support structure for supporting a patterning device, a handling apparatus for handling the patterning device, and a controller, wherein the controller is configured to bring the patterning device and the support structure together, energize a clamp which secures the patterning device to the support structure, and then separate the handling apparatus and the patterning device, wherein the controller is configured to provide a plasma between the handling apparatus and the patterning device whilst the handling apparatus and the patterning device are separating.

15. A lithographic system comprising the lithographic apparatus of claim 14 and further comprising a radiation source, wherein the controller is configured to provide the plasma by moving a masking blade such that it blocks an EUV radiation beam provided by the radiation source.
